# EUROPEAN PATENT SPECIFICATION

(11) **EP 1 024 155 B1**
(45) Date of publication and mention of the grant of the patent: **22.10.2003**
(21) Application number: 98937786.6
(22) Date of filing: 12.08.1998
(51) Int. Cl.: C08G 14/10

(54) **PHENOL/TRIAZINE DERIVATIVE CO-CONDENSATE RESIN AND PROCESS FOR PRODUCING THE SAME**
COKONDENSIERTE HARZZUSAMMENSETZUNGEN AUS PHENOL/TRIAZIN DERIVATEN SOWIE VERFAHREN ZU DEREN HERSTELLUNG
RESINE CO-CODENSEE D'UN DERIVE DE PHENOL ET DE TRIAZINE

(43) Date of publication of application: 02.08.2000
(73) Proprietor: GUN EI CHEMICAL INDUSTRY CO., LTD., Takasaki-shi, Gunma-ken 370 (JP)
(72) Inventor: NAKAYAMA, Takeshige Gun Ei Chem. Ind. Co., Ltd., Takasaki-shi Gunma 370-0032 (JP); KURIMOTO, Yoshiaki Gun Ei Chem. Ind. Co., Ltd., Takasaki-shi Gunma 370-0032 (JP); TAKAGI, Seiji Gun Ei Chem. Industry Co., Ltd., Takasaki-shi Gunma 370-0032 (JP)
(74) Representative: HOFFMANN - EITLE
(86) International application number: JP9803583
(87) International publication number: WO00009579

(56) References cited:
- JP-A- 3 243 613
- JP-A- 3 265 618
- JP-A- 4 292 612
- JP-A- 55 135 123
- JP-A- 55 152 714
- JP-A- 58 104 918

## Description

The present invention relates to phenol triazine derivative co-condensation resins, and a manufacturing method thereof.

Phenol resins obtained by condensation of phenol and formaldehyde display excellent durability, heat resistance and resistance to hydrolysis, but have undesirably slow curing times. Furthermore, melamine resins obtained by condensation of melamine and formaldehyde display good curability, but are inferior to phenol resins in terms of durability, heat resistance and resistance to hydrolysis.

As a result, recent tests have attempted to produce co-condensation resins of phenol and melamine which combine the advantages of the two resins, but simple co-condensation of phenol, melamine and formaldehyde results in the condensation of two molecules of melamine occurring preferentially over co-condensation between melamine and phenol, and yields only resins in which the proportion of melamine-melamine bonding and phenol-phenol bonding is greater than the proportion of melamine-phenol bonding, thus making it difficult to produce a resin which combines the advantages of the two individual resins.

In order to resolve the above problems, a manufacturing method for phenol melamine resins is proposed in Japanese Patent Application, First Publication No. Sho. 55-108415, wherein calcium hydroxide is added to a mixture of melamine, phenol and formaldehyde to adjust the pH to 8, and then following a reflux reaction at 97°C, a novolak phenol resin and polyethylene glycol are added to the mixture and dehydration conducted under reduced pressure. With this method the amount of free phenol is able to be reduced, but the proportion of melamine-melamine bonding and phenol-phenol bonding remains greater than the proportion of melamine-phenol bonding, and so the desired effects of co-condensation are not sufficiently realized.

Another manufacturing method for phenol melamine resin with an enhanced co-condensation ratio is disclosed in Japanese Patent Application, First Publication No. Hei. 3-243613, wherein phenol, formalin and calcium hydroxide are reacted at 50°C, the pH adjusted to 3.5 by addition of sulfuric acid, and then following the addition of melamine to the reaction solution and reaction for 60 minutes at 85°C, sodium hydroxide is added and the mixture cooled. However, with this method the occurrence of melamine-melamine bonding is still of a similar level to melamine-phenol bonding, and the co-condensation ratio is only between 30∼65%.

Furthermore, in each of the methods disclosed in Japanese Patent Application, First Publication No. Sho. 55-108415, and Japanese Patent Application, First Publication No. Hei. 3-243613, methylol groups still exist within the molecular structure of the resins obtained, and so poisons such as formaldehyde can be generated during curing which has a deleterious effect on the working environment.

In Japanese Patent Application, First Publication No. Hei. 9-124896, a method is disclosed for obtaining phenol melamine resin, wherein a mixture comprising phenol, melamine, formalin and triethylamine is heated to 100°C and then dehydration carried out by slowly raising the temperature to 180°C over a period of two hours, with any unreacted phenol then being removed under reduced pressure. However, even with this method the occurrence of melamine-melamine bonding can not be suppressed, and the co-condensation ratio is not able to be increased significantly. Furthermore, in the method of Japanese Patent Application, First Publication No. Hei. 9-124896, because the molecular weight distribution is broad, if the denaturation ratio (modification ratio) of melamine is increased then the viscosity of the resin increases, making handling difficult and inviting other problems such as extreme increases in the softening point temperature.

JP-A-58-104918 is directed to a process according to which a methyl-etherified methylol melamine varnish is obtained by a reaction between melamine, formaline and methanol, and the resulting mixture is reacted with a mixture obtained from reacting phenol and formaline at reaction temperatures of 80°C or below.

JP-A-55-152714 describes a method, wherein phenol and formaline are reacted to yield a methylol phenol initial condensate, which subsequently is reacted with melamine and methanol. The reaction temperature in any step is 80°C or less.

JP-A-55-135123 discloses a method comprising the reaction of melamine, formaldehyde and methanol in a first step, to yield a denatured melamine resin. Separately, phenol and formaldehyde are reacted to yield a phenol initial condensate. The denatured melamine resin and phenol initial condensate are then mixed and reacted at a low temperature of 60°C.

The present invention takes the above situations into consideration, with the object of providing a phenol triazine derivative co-condensation resin and a manufacturing method thereof, in which the co-condensation ratio of the phenol and the triazine derivative is high and the molecular weight distribution of the produced resin is narrow.

A phenol triazine derivative co-condensation resin according to the present invention is a co-condensate of a triazine derivative and a phenol, wherein the average proportion of the amount of [-NH-CH₂-phenol] bonding expressed, as a percentage of the total bonding incorporating [-NH-CH₂-phenol] bonding, [-NH-CH₂-NH-] bonding and [phenol-CH₂-phenol] bonding, is between 30∼80% as measured by ¹³C-NMR for example, and wherein the number average molecular weight (Mn) is between 300∼800, and the ratio (Mw/Mn) of the weight average molecular weight (Mw) to the number average molecular weight (Mn) is no more than 1.30.

Phenol triazine derivative co-condensation resins of this type display high rates of co-condensation of the phenol and the triazine derivative, and because the amount of nitrogen incorporation is necessarily high, also display high levels of flame retardancy. Furthermore being novolak type resins, no toxic gas is generated during curing, and as the molecular weight distribution is narrow, viscosity remains low even if the denaturation ratio of the triazine derivative is high, making manufacturing simple. Moreover, the resins display excellent resistance to heat and humidity, and because no free triazine derivative remains, the resins are uniform and degradation of compatibility is unlikely to occur.

A first manufacturing method for preparing a phenol triazine derivative co-condensation resin according to the present invention is characterized by comprising: a step for preparing a methylolated triazine derivative wherein an aldehyde undergoes an addition reaction with a triazine derivative; a step for preparing an alkylated methylol triazine derivative wherein the aforementioned methylolated triazine derivative undergoes a substitution reaction with an alcohol; and a step for manufacturing the phenol triazine derivative co-condensation resin wherein a phenol is added to the alkylated methylol triazine derivative and the mixture then heated to effect a co-condensation reaction through a dealcoholization reaction and a dehydration concentration.

With this method, it is also possible to manufacture the phenol triazine derivative co-condensation resin by selectively generating the methylolated triazine derivative by mixing the triazine derivative, the aldehyde, the phenol, and the alcohol, and then generating the alkylated methylol triazine derivative by a substitution reaction of the methylolated triazine derivative with the aforementioned alcohol, and finally conducting a co-condensation of the alkylated methylol triazine derivative and the phenol by heating the mixture following the formation of the alkylated methylol triazine derivative.

With the method described above, by converting the triazine derivative into an alkylated methylol triazine derivative the reactivity between two molecules of the triazine derivative is lowered, while the reactivity between the triazine derivative and the phenol is increased. Consequently, not only can the co-condensation ratio between the triazine derivative and the phenol be improved significantly, but furthermore by inhibiting the inherently fast condensation of the triazine derivative, an ununiform high molecular weight can be prevented, and the molecular weight distribution is able to be kept narrow. As a result, a resin composition is achieved which is easy to handle, and for which properties such as viscosity are uniform.

A second manufacturing method according to the present invention is characterized by comprising: a step for preparing a methylolated phenol wherein an aldehyde undergoes an addition reaction to a phenol; a step for preparing an alkylated methylol phenol wherein the methylolated phenol undergoes a substitution reaction with an alcohol; and a step for manufacturing the phenol triazine derivative co-condensation resin wherein a triazine derivative is added to the alkylated methylol phenol and the mixture then heated to effect a co-condensation reaction through a dealcoholization reaction and a dehydration concentration.

With the method described above, by first converting the phenol into an alkylated methylol phenol the reactivity between the triazine derivative and the phenol is able to be increased beyond the reactivity of two molecules of the triazine derivative. Consequently, not only can the co-condensation ratio between the phenol and the triazine derivative be improved significantly, but furthermore by inhibiting the inherently fast condensation of the triazine derivative, an ununiform high molecular weight can be prevented, and the molecular weight distribution is able to be kept narrow.

### BRIEF DESCRIPTION OF THE DRAWINGS

FIGS. 1∼5 are graphs showing the GPC spectra for the resins prepared in working examples 1∼5 respectively of the present invention.
FIGS. 6 and 7 are graphs showing the GPC spectra for the resins prepared in comparative examples 1 and 2 respectively of the present invention.

### DESCRIPTION OF THE PREFERRED EMBODIMENTS

As follows is a detailed description of embodiments of the present invention.

A phenol triazine derivative co-condensation resins according to the present invention is a co-condensate of a triazine derivative and a phenol, wherein the average proportion of the amount of [-NH-CH₂-phenol] bonding expressed as a percentage of the total bonding incorporating [-NH-CH₂-phenol] bonding, [-NH-CH₂-NH-] bonding and [phenol-CH₂-phenol] bonding (hereafter termed the "bonding ratio") is between 30∼80%. Furthermore, the number average molecular weight (Mn) of the resin is between 300∼800, and the ratio (Mw/Mn) of the weight average molecular weight (Mw) to the number average molecular weight (Mn) is no more than 1.30.

The bonding ratio can be easily determined using ¹³C-NMR measurements for example. With ¹³C-NMR measurements, the absorption region for [-NH-CH₂-phenol] bonds is in the vicinity of 41ppm (41.2ppm), the absorption region for [-NH-CH₂-NH-] bonds is in the vicinity of 45ppm (45.5ppm), and the absorption region for [phenol-CH₂-phenol] bonds is in the vicinity of 31ppm for 2-2', 44ppm for 2-4', and 41ppm for 4-4', and consequently by determining the ratio of the integral of each type of CH₂ bond with respect to the combined integrals of all the CH₂ bonds, the bonding ratio can be determined.

The bonding ratio is a measure of the co-condensation ratio of the triazine derivative and the phenol, and at bonding ratios less than 30% the durability, heat resistance, and resistance to hydrolysis of the resin is relatively lower. At bonding ratios greater than 80% the resin manufacture becomes difficult making such resins unrealistic. Preferred bonding ratios are between 50∼80%, with values between 60∼70% being the most suitable.

The aforementioned triazine derivative is a compound of the structure shown in the formula (I) below. 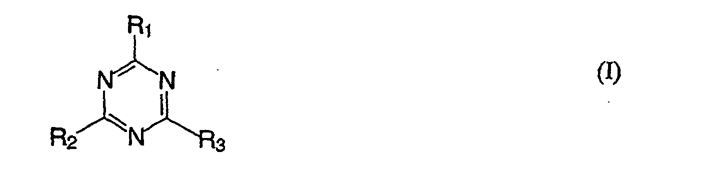 In the formula (I), R1, R2, and R3 each represent one of the group consisting of an alkylated methylol group, a hydrogen atom, an amino group, an alkyl group, a phenyl group, a hydroxyl group, a hydroxylalkyl group, an ether group, an ester group, an acid group, an unsaturated group, a cyano group, or a halogen atom.

In the formula (I) above, it is desirable that at least two of the groups R1, R2 and R3 are alkylated methylol groups. Examples of such preferred triazine derivatives include either one, or alternatively a mixture of two or more, of the compounds selected from di-(alkylated methylol) melamine, tri-(alkylated methylol) melamine, di-(alkylated methylol) benzoguanamine, and di-(alkylated methylol) acetoguanamine.

A phenol triazine derivative co-condensation resin of the present invention should preferably be composed primarily of a mixture of a three nucleus compound of the basic structure shown in the formula (II) below, a four nucleus compound of the basic structure shown in the formula (III), a five nucleus compound of the basic structure shown in the formula (IV), and a six nucleus compound of the basic structure shown in the formula (V). The hydrogen atoms shown in the chemical formulae can also be substituted with other groups such as amino groups, alkyl groups, phenyl groups, hydroxyl groups, hydroxylalkyl groups, ether groups, ester groups, acid groups, unsaturated groups, cyano groups, or halogen atoms. In the description above, "composed primarily of" means that at least 80% by weight of the entire resin should be composed of the aforementioned three nucleus compound, four nucleus compound, five nucleus compound, and six nucleus compound. 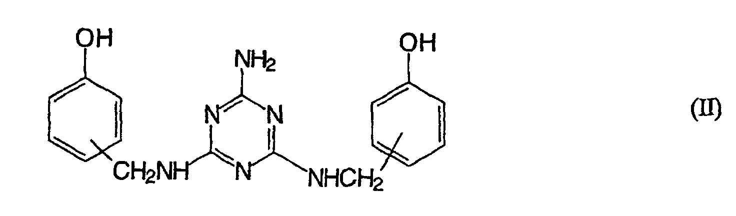 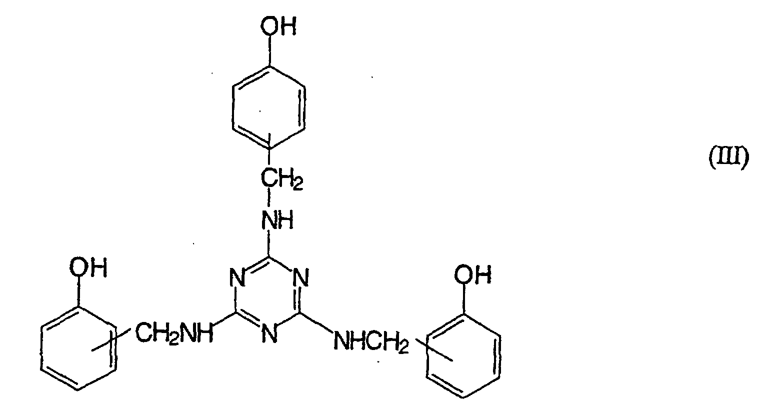 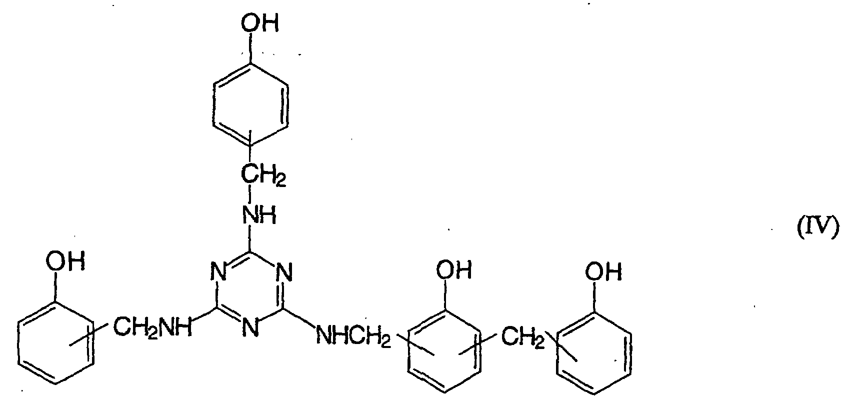 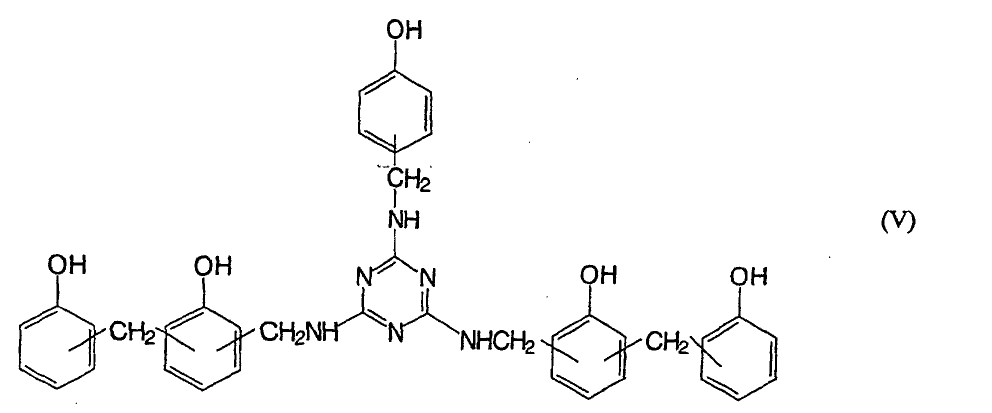 In addition to the above compounds, a resin of the present invention may also comprise up to 20% by weight of the entire resin of unavoidable impurities such as the compounds of the basic structures shown in the formulae (VI), (VII) and (VIII) below, as well as straight novolak (novolak which has not bonded with the triazine derivative). Of these impurities, it is preferable that the amount of straight novolak incorporated in the resin is no more than 5% by weight.

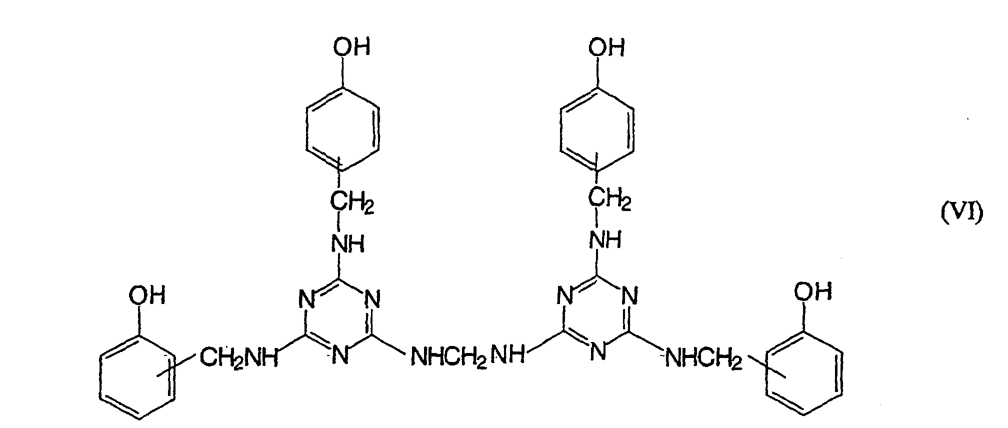

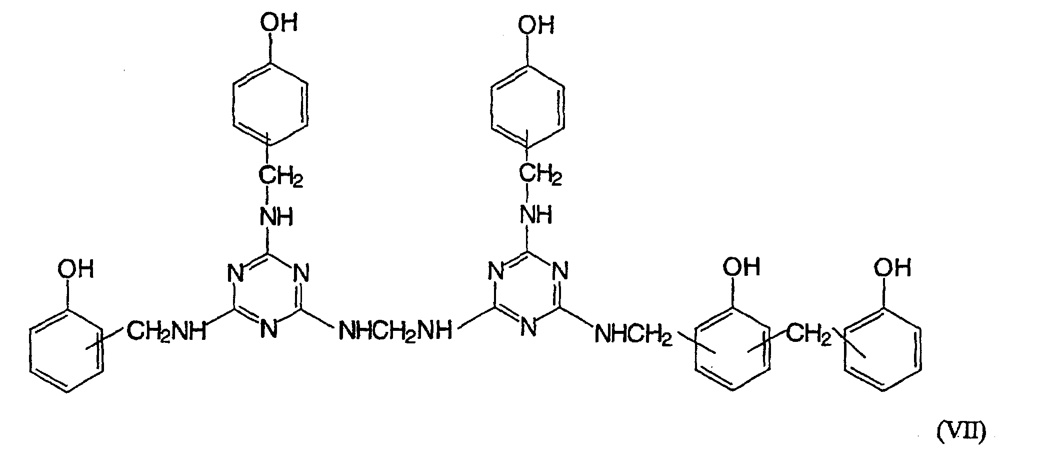

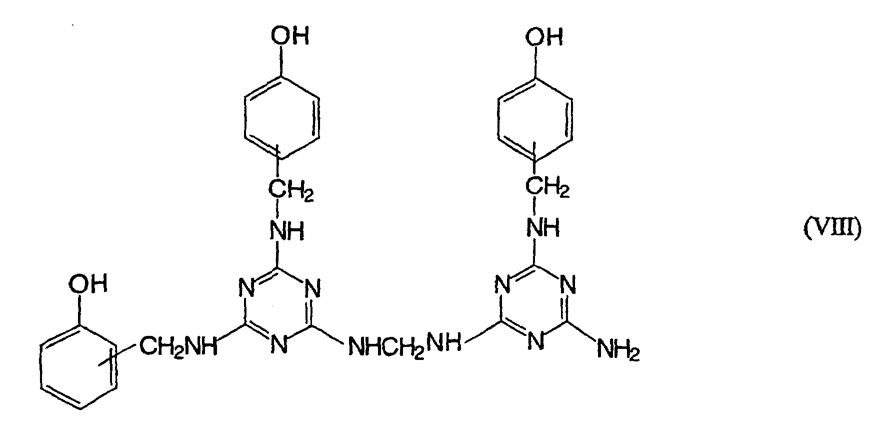

With a phenol triazine derivative co-condensation resin of the present invention the molecular weight distribution is narrow and the bonding ratio between phenol and melamine is high, and moreover the phenol and melamine are arranged in a regular, approximately alternating pattern, and so the denaturation ratio (modification ratio) of the melamine is high. Hence, because of the high level of nitrogen incorporation, the resin displays good flame retardancy and heat resistance even if halogen groups are not incorporated in the structure. Furthermore being of a novolak type, the resin has the great advantage of not releasing toxic gas during curing.

As described below, at least a portion of the aforementioned triazine derivative, or alternatively a portion of the OH groups of the phenol may be modified by an epoxy group. With such an epoxy modified phenol triazine derivative co-condensation resin, exactly the same effects are achieved when used as a curing agent. Hence, the same flame retardant effects are achieved when a melamine denatured novolak is combined with an epoxylated epoxy resin and a typical curing agent, as when a melamine denatured novolak is used as the curing agent with a typical epoxy resin (such as a bisphenol A type resin). Sufficient flame retardant effect can be achieved by using a melamine denatured compound with either one of the epoxy resin or the curing agent, but by using a melamine denatured compound with both, an even better flame retardancy is achieved.

As follows is a detailed description of the manufacturing method of the above resin.

### [First manufacturing method]

In a first step of a first manufacturing method according to the present invention, an aldehyde undergoes an addition reaction with a triazine derivative to yield a methylolated triazine derivative.

Examples of suitable triazine derivatives include melamine, acetoguanamine, benzoguanamine, cyanuric acid, methyl cyanurate, ethyl cyanurate, acetyl cyanurate and cyanuryl chloride. Of these, compounds such as melamine, acetoguanamine and benzoguanamine, where either two or three of the groups R1, R2 and R3 of the formula (I) are amino groups, are preferable. Furthermore, from the viewpoint of increasing the flame retardancy of the resin, compounds such as melamine, acetoguanamine and benzoguanamine, which have a greater number of nitrogen atoms and fewer oxygen atoms within the molecule, are preferable.

Although there are no particular restrictions on the aldehyde used with the present invention, from an industrial viewpoint, considering cost and ease of handling, aldehydes such as formalin and paraformaldehyde are preferable.

There are no particular restrictions on the mol ratio of the aldehyde with respect to the triazine derivative, but mol ratios between 0.5∼6.0 are preferable, with values between 1.5∼4.0 being even more desirable, and ratios between 2.0∼3.5 being the most suitable. At mol ratios less than 0.5 unreacted triazine derivative is left over following reaction which is undesirable, whereas at mol ratios greater than 6.0 there is an undesirable diminishing of the improvement in flame retardancy effect.

Although there are no particular restrictions on the system pH during the addition reaction, values between pH5∼8 require no catalyst and so are preferable. Another benefit of the methods of the present invention is that the use of catalysts and pH regulating agents is not required. At values less than pH5 the condensation between melamine molecules proceeds rapidly, whereas at values greater than pH8 the use of catalysts becomes necessary which is undesirable from the viewpoint of cost. Particularly preferable pH values are between pH6∼7.

The reaction temperature should preferably be within the range 50∼80°C, with the reaction time at such temperatures being of the order 0.5∼2.0 hours. At reaction temperatures less than 50°C the reaction does not proceed to completion and the problem arises of unreacted free formalin, whereas at temperatures greater than 80°C the condensation between molecules of the triazine derivative accelerates, increasing the danger of gelation. Particularly desirable reaction temperatures are within the range 60∼70°C.

Next, in a second step, the methylolated triazine derivative undergoes a substitution reaction with an alcohol to produce an alkylated methylol triazine derivative. By converting the triazine derivative into an alkylated methylol triazine derivative in this manner, the reactivity thereof at the subsequent third step is reduced, enabling the bonding with the phenol to occur preferentially and thus ensuring an increase in the phenol triazine derivative co-condensation ratio, which enables the manufacture of resins with the aforementioned bonding ratios.

The aforementioned alcohol should preferably be a monovalent alcohol such as methanol, ethanol or butanol. In particular, methanol, which from an industrial viewpoint offers the advantages of low cost and good reactivity, is preferable.

The mol ratio of the alcohol with respect to the triazine derivative should preferably be within the range 1∼20. At mol ratios less than 1, the bonding ratio between triazine derivative molecules increases, whereas at ratios greater than 20 the amount of excess alcohol which does not participate in the reaction increases, thus diminishing the yield. Mol ratios within the range 5∼15 are even more desirable, with ratios between 7~10 being the most suitable.

The pH of the reaction system should preferably be between pH5∼8, as at values less than pH5 the condensation between molecules of the triazine derivative proceeds too rapidly, whereas at values greater than pH8 the use of catalysts becomes necessary which is undesirable. Particularly preferable pH values are between pH6∼7.

The reaction temperature should preferably be within the range 50∼80°C, with the reaction time at such temperatures being of the order 0.5∼5 hours. The reaction is best conducted with a reflux apparatus. At reaction temperatures less than 50°C the reaction does not proceed to completion and problems arise due to the remaining unsubstituted methylol groups, whereas at temperatures greater than 80°C the condensation between molecules of the triazine derivative accelerates, increasing the danger of gelation. Particularly desirable reaction temperatures are within the range 60∼70°C.

Next, in a third step, a phenol is added to the alkylated methylol triazine derivative and the reaction system then heated, and a co-condensation proceeds via a dealcoholization and a dehydration concentration, to yield a phenol triazine derivative co-condensation resin. There is no necessity to include a solvent during this step, as the alkyl methylolation suppresses the reactivity of the triazine derivative.

There are no particular restrictions on the phenol used with the present invention, although suitable examples include phenol; alkyl phenols such as cresol, xylenol, ethyl phenol, butyl phenol, nonyl phenol and octyl phenol; polyhydric phenols such as bisphenol A, bisphenol F, bisphenol S, resorcinol and catechol; and phenyl phenol and aminophenol. Furthermore, the phenol is not restricted to a single phenol, but may also be a combination of two or more such phenols. Of the above phenols, phenol, cresol and xylenol are particularly preferred, as the softening points of the products thus generated are very suitable, making them easy to use in an industrial setting.

The mol ratio of the phenol with respect to the triazine derivative should preferably be within the range 1~20. At mol ratios less than 1, the bonding ratio between triazine derivative molecules increases, whereas at ratios greater than 20 the amount of excess phenol which does not participate in the reaction increases, thus diminishing the yield. Mol ratios within the range 5~15 are even more desirable, with ratios between 7∼10 being the most suitable.

The maximum heating temperature during the dealcoholization reaction and the dehydration concentration should preferably be greater than 120°C, with temperatures between 160∼200°C being the most suitable. At maximum heating temperatures lower than 120°C the reaction does not progress sufficiently well.

Once the co-condensation is complete, the resin can be removed. The viscosity of the prepared resin is typically of the order 100∼1000cP at 200°C.

### [Second manufacturing method]

In the first manufacturing method described above, the method was divided into a first, second and third step which were carried out separately, but even in the case where all the raw materials are batch mixed, it is still possible to ensure that the chemical reactions progress in the same order as that described by the first, second, and third steps above.

Thus, by batch mixing the triazine derivative, the aldehyde, the phenol and the alcohol described above, a methylolated triazine derivative is generated selectively due to the differing reactivities, and the thus generated methylolated triazine derivative then undergoes an alcohol substitution reaction with the alcohol to form an alkylated methylol triazine derivative, and by heating the reaction mixture following the formation of the alkylated methylol triazine derivative, a co-condensation reaction with the phenol enables the manufacture of a phenol triazine derivative co-condensation resin.

This second method offers the advantage of a simplification of the manufacturing operation, associated with being able to batch mix all the raw materials. The reaction conditions are the same as those described above for the first manufacturing method.

### [Third manufacturing method]

In a third manufacturing method of the present invention, a first step involves an addition reaction of an aldehyde to a phenol to yield a methylolated phenol. The phenol and aldehyde are of the same type as those described above for the first manufacturing method.

There are no particular restrictions on the mol ratio of the aldehyde with respect to the phenol, but mol ratios between 0.5~6.0 are preferable, with values between 1.5∼4.0 being even more desirable, and ratios between 2.0∼3.5 being the most suitable. At mol ratios less than 0.5 unreacted phenol is left over following reaction which is undesirable, whereas at mol ratios greater than 6.0 free formalin remains in the mixture, so that when a triazine derivative is subsequently added, the undesirable condensation reaction between molecules of the triazine derivative is more likely to occur.

Although there are no particular restrictions on the system pH during the reaction, values between pH5∼8 require no catalyst and so are preferable. Another benefit of the methods of the present invention is that the use of catalysts and pH regulating agents is not required. At values less than pH5 the condensation between phenol molecules proceeds rapidly, whereas at values greater than pH8 the use of catalysts becomes necessary which is undesirable. Particularly preferable pH values are between pH6∼7.

The reaction temperature should preferably be within the range 50∼100°C, with the reaction time at such temperatures being of the order 0.5∼4 hours. At reaction temperatures less than 50°C the reaction does not proceed to completion and the problem arises of unreacted free formalin, whereas at temperatures greater than 100°C there is a danger of gelation. Particularly desirable reaction temperatures are within the range 70∼80°C.

Next, in a second step, the methylolated phenol undergoes a substitution reaction with an alcohol to produce an alkylated methylol phenol. The alcohol is of the same type as that described above for the first manufacturing method.

The mol ratio of the alcohol with respect to the phenol should preferably be within the range 1~20. At mol ratios less than 1, the bonding ratio between phenol molecules increases, whereas at ratios greater than 20 the amount of excess alcohol which does not participate in the reaction increases, thus diminishing the yield. Mol ratios within the range 5~15 are even more desirable, with ratios between 7~10 being the most suitable.

The pH of the reaction system should preferably be between 10~14, as at values less than pH10 the substitution reaction does not progress well. Particularly suitable pH values are between pH12∼13. In order to adjust the pH to a value within the preferred range, a compound such as an alkali metal hydroxide, an alkali earth metal hydroxide, or 1,8-diazabicyclo-7-undecene (DBU) is added to the reaction mixture.

The reaction temperature should preferably be within the range 50∼100°C, with the reaction time at such temperatures being of the order 0.5∼4 hours. The reaction is best conducted with a reflux apparatus. At reaction temperatures less than 50°C the reaction does not proceed to completion and the problem of unsubstituted methylol groups arises, whereas at temperatures greater than 100°C there is a danger of gelation. Particularly desirable reaction temperatures are within the range 70∼80°C.

Next, in a third step, a triazine derivative is added to the alkylated methylol phenol and the mixture is heated, and a co-condensation proceeds via a dealcoholization reaction and a dehydration concentration, to yield a phenol triazine derivative co-condensation resin. As there is no free formalin in the system during reaction, molecules of the triazine derivative do not inter-react.

The triazine derivative can be the same as those compounds described in the aforementioned first manufacturing method. The mol ratio of the phenol with respect to the triazine derivative should preferably be within the range 1∼20. At mol ratios less than 1, the bonding ratio between molecules of the triazine derivative increases, whereas at ratios greater than 20 the amount of excess phenol which does not participate in the reaction increases, thus diminishing the yield. Mol ratios within the range 5~15 are even more desirable, with ratios between 7∼10 being the most suitable.

The maximum heating temperature during the dealcoholization reaction and the dehydration concentration should preferably be greater than 120°C, with temperatures between 160∼200°C being the most suitable. At maximum heating temperatures lower than 120°C the reaction does not progress sufficiently well.

Once the co-condensation is complete, the resin can be cooled and removed. The physical properties of the prepared resin are substantially the same as those of the first manufacturing method.

Of the first, second, and third manufacturing methods described above, from the viewpoints of narrowing the molecular weight distribution and increasing the co-condensation ratio of the triazine derivative and the phenol, the first manufacturing method is the most preferred. The reason that the first manufacturing method is able to narrow the molecular weight distribution and increase the co-condensation ratio is that by converting the triazine derivative into an alkylated methylol derivative the reactivity can be controlled to ensure preferential bonding with the phenol.

The phenol triazine derivative co-condensation resins obtained by the above manufacturing methods can be used in laminates (printed circuit boards), friction materials, refractory products, and sealants for semiconductor packages, as well as in the manufacture of grinding stones and molding materials. In order to use the resins in each of the above materials, either the phenol triazine derivative co-condensation resin can be mixed with a suitable curing agent and filler and then heat cured, or alternatively the phenol triazine derivative co-condensation resin can be added to an epoxy resin as the curing agent and the subsequent mixture heat cured.

Examples of the curing agent which can be added to the phenol triazine derivative co-condensation resins include either one, or alternatively a mixture of two or more hexamethylenetetramines, and the amount of curing agent added should preferably be between 5∼20 parts by weight of the curing agent per 100 parts by weight of the phenol triazine derivative co-condensation resin, with values between 10∼15 parts by weight being even more desirable. The curing conditions involve heating at a temperature of 120∼200°C for a period of 0.5∼3.0 minutes.

In the case where the phenol triazine derivative co-condensation resin is used as the curing agent for hardening an epoxy resin, then preferably between 50~80 parts by weight of the phenol triazine derivative co-condensation resin should be used per 100 parts by weight of the epoxy resin, with values between 60∼70 parts by weight being even more desirable. Favourable curing conditions involve heat molding at 150∼200°C for a period of 2∼10 minutes, followed by 1∼10 hours of after cure.

Suitable fillers include either one, or mixtures of two or more, of the materials selected from the group comprising alumina, attapulgite, kaolin, carbon black, graphite, silicon oxide, calcium silicate, magnesium oxide, titanium oxide, iron oxide, magnesium hydroxide, aluminium hydroxide, slate powder, sericite, calcium carbonate, magnesium carbonate, talc, feldspar powder, molybdenum disulfide, barytes, mica, and anhydrous gypsum.

At least a portion of the aforementioned triazine derivative section of the phenol triazine derivative co-condensation resin of the present invention, and a portion of the OH groups of the phenol section may be modified by an epoxy group. In such a case, an epihalohydrin and the phenol triazine derivative co-condensation resin are mixed together and allowed to react. Examples of epihalohydrins include epichlorohydrin, β-methyl epichlorohydrin, epibromohydrin, β-methyl epibromohydrin, epiiodohydrin, and β-ethyl epichlorohydrin, but of these epichlorohydrin is particularly desirable, being industrially easy to obtain, and of low cost. The reaction is carried out by adding a solid alkali metal hydroxide such as sodium hydroxide or potassium hydroxide, either in a single batch or gradually over time, to a mixture of the epihalohydrin and the phenol triazine derivative co-condensation resin, and then allowing the reaction to proceed for a period of 30 minutes∼10 hours at a temperature of 20∼120°C. The amount of epihalohydrin added to the mixture should preferably be between 0.5~20 mols per mol equivalent of hydroxyl groups within the phenol triazine derivative co-condensation resin, with values between 0.7~10 mols being even more desirable, and the amount of alkali metal hydroxide added should preferably be between 0.5∼1.5 mols per mol equivalent of hydroxyl groups within the phenol triazine derivative co-condensation resin, with values between 0.7~1.2 mols being even more desirable.

The epoxy modified phenol triazine derivative co-condensation resin thus obtained is an epoxy resin which offers the advantages of displaying excellent properties of flame retardancy and heat resistance, and consequently is suitable for use in filling materials, laminates, friction materials and refractory products. The lower the density of epoxy groups the greater the flexibility of the resin, and so the gram equivalence of epoxy groups incorporated in 100g of the epoxy resin (called the epoxy content) should preferably be within the range 0.2∼0.4mol/100g.

### WORKING EXAMPLES

Next, a series of working examples are described to demonstrate the effects of the present invention.

### [Working example 1] First manufacturing method / molecular weight: relatively low

81 parts of 37% formalin were added to 126 parts of melamine, and the temperature was raised to 80°C. Following reaction for a period of one hour at 80°C, 320 parts of methanol were added and the mixture refluxed for two hours. 846 parts of phenol were then added to the reaction solution and a demethanolization reaction and a dehydration conducted under normal pressure while the temperature was raised to 180°C, with any residual unreacted phenol then being removed under reduced pressure. The softening point of the thus produced phenol melamine co-condensation resin composition was 129°C.

### [Working example 2] First manufacturing method / molecular weight: medium

162 parts of 37% formalin were added to 126 parts of melamine, and the temperature was raised to 70°C. Following reaction for a period of 30 minutes at 70°C, 320 parts of methanol were added and the mixture refluxed for two hours. 846 parts of phenol were then added to the reaction solution and a demethanolization reaction and a dehydration conducted under normal pressure while the temperature was raised to 180°C, with any residual unreacted phenol then being removed under reduced pressure. The softening point of the thus produced phenol melamine co-condensation resin composition was 133°C.

### [Working example 3] First manufacturing method / molecular weight: relatively high

284 parts of 37% formalin were added to 126 parts of melamine, and the temperature was raised to 70°C. Following reaction for a period of 30 minutes at 70°C, 160 parts of methanol were added and the mixture refluxed for two hours. 846 parts of phenol were then added to the reaction solution and a demethanolization reaction and a dehydration conducted under normal pressure while the temperature was raised to 180°C, with any residual unreacted phenol then being removed under reduced pressure. The softening point of the thus produced phenol melamine co-condensation resin composition was 140°C.

### [Working example 4] First manufacturing method / molecular weight: relatively high, uses benzoguanamine

180 parts of 50% formalin were added to 187 parts of benzoguanamine, and the temperature was raised to 75°C. Following reaction for a period of one hour at 75°C, 320 parts of methanol were added and the mixture refluxed for two hours. 470 parts of phenol were then added to the reaction solution and a demethanolization reaction and a dehydration conducted under normal pressure while the temperature was raised to 180°C, with any residual unreacted phenol then being removed under reduced pressure. The softening point of the thus produced phenol benzoguanamine co-condensation resin composition was 127°C.

### [Working example 5] Second manufacturing method / molecular weight: relatively high

To 846 parts of phenol was added 126 parts of melamine, 284 parts of 37% formalin, and 320 parts methanol, with the temperature of the reaction mixture then raised to 80°C. Following reaction for a period of two hours at 80°C, a demethanolization reaction and a dehydration were conducted under normal pressure while the temperature was raised to 180°C, with any residual unreacted phenol then being removed under reduced pressure. The softening point of the thus produced phenol melamine co-condensation resin composition was 140°C.

### [Comparative example 1] Equivalent to the second working example of Japanese Patent Application, First Publication No. Hei. 8-183827

To 1300 parts of phenol, 193 parts of melamine and 553 parts of 50% formalin contained in a reaction vessel was added 52 parts of oxalic acid, and the temperature was then raised gradually to 80°C. The temperature was then increased further, and the reaction mixture refluxed for four hours at 95°C. Next, a dehydration reaction was carried out at normal pressure while the temperature was raised to 200°C, and once the temperature reached 200°C the pressure was reduced to 14.2kPa and a dehydration conducted for a period of one hour. Following dehydration, the product was removed from the reaction vessel and yielded a solid phenol melamine co-condensation resin at room temperature. The softening point was 145°C.

### [Comparative example 2] Equivalent to the first synthetic example of Japanese Patent Application, First Publication No. Hei. 9-124896

94 parts of phenol, 19 parts of melamine, 43 parts of 41.5% formalin and 0.19 parts of triethylamine were combined and the temperature raised to 100°C. Following reaction for five hours at 100°C, moisture was removed at normal pressure while the temperature was gradually raised to 180°C over a period of two hours, and then unreacted phenol was removed at reduced pressure to yield a phenol melamine co-condensation resin of softening point 160°C.

### [Comparative example 3] Equivalent to the first working example of Japanese Patent Application, First Publication No. Hei. 3-243613

200g of phenol, 517g of 37% formalin and 11.8 g of calcium hydroxide were combined and the mixture cooled until dissolution was complete, with the resulting solution then subsequently being reacted for 8 hours at 50°C. Following cooling of the reaction solution to 35°C, 30g of 50% sulfuric acid was dripped into the solution. Next, 127g of melamine was added to the reaction solution, and the resulting mixture reacted for 60 minutes at 85°C. The reaction mixture was then cooled to 35°C, 10g of sodium hydroxide added, and the system then cooled even further which resulted in gelation and solidification.

### [Comparative example 4] Equivalent to the second working example of Japanese Patent Application, First Publication No. Hei. 3-243613

200g of phenol, 517g of 37% formalin and 42.4 g of sodium hydroxide were combined and the mixture cooled until dissolution was complete, with the resulting solution then subsequently being reacted for 8 hours at 50°C. Following cooling of the reaction solution to 35°C, 125g of 50% sulfuric acid was dripped into the solution. Next, 127g of melamine was added to the reaction solution, and the resulting mixture reacted for 60 minutes at 85°C. An additional 100g of 37% formalin was then added and the reaction allowed to proceed for a further 60 minutes. The reaction mixture was then cooled to 35°C, 20g of sodium hydroxide added, and the system then cooled even further which resulted in gelation and solidification.

### [Comparative example 5] Equivalent to the third working example of Japanese Patent Application, First Publication No. Hei. 3-243613

248g of melamine, 162g of 37% formalin and 42.4 g of sodium hydroxide were combined and the mixture cooled until dissolution was complete, with the resulting solution then subsequently being reacted for one hour at 57°C and the reaction solution then cooled to 35°C. This yielded reactant A.

In addition, 200g of phenol, 517g of 37% formalin and 42.4 g of sodium hydroxide were combined and the mixture cooled until dissolution was complete, with the resulting solution then subsequently being reacted for 8 hours at 50°C. Following cooling of the reaction solution to 35°C, 125g of 50% sulfuric acid was dripped into the solution. Next, 127g of the reactant A was added to the reaction solution, and the resulting mixture reacted for 60 minutes at 85°C. The reaction mixture was then cooled to 35°C, 20g of sodium hydroxide added, and the system then cooled even further which resulted in gelation and solidification.

### [Comparative experiments]

The resin compositions of the working examples 1∼5 and the comparative examples 1∼2 were analyzed by ¹³C-NMR with the densities of [-NH-CH₂-phenol] bonding, [-NH-CH₂-NH-] bonding, [phenol-CH₂-phenol] bonding, and [-NH-CH₂-OH] bonding measured, and the respective bonding ratios then calculated. The measurements were conducted using a JNM-LA400 type nuclear magnetic resonance apparatus made by Japan Electron Optics Laboratory Corporation, Ltd (JEOL). The results of the measurements are shown in table 1.

Furthermore for each resin composition, the weight average molecular weight (Mw), the number average molecular weight (Mn), the nitrogen incorporation rate, and the softening point (R&B method) were measured, and the amounts of unreacted formaldehyde, phenol and triazine derivative were also measured. The measurements of the weight average molecular weight (Mw) and the number average molecular weight (Mn) were conducted using a high speed GPC apparatus (HLC-8020) made by Toso Corporation. The columns used were a single TSK-GEL G3000H_{XL} column and two TSK-GEL G2000H_{XL} columns. The measurements of the nitrogen incorporation rate were conducted by subtracting the distilled phenol from the value of the initial combination. The measurements of the amounts of unreacted material were carried out by determining the acetone insoluble portion (unreacted material) from a Soxhlet extraction. The results are shown in table 1.

As can be seen clearly from table 1, the phenol triazine derivative co-condensation resins according to the present invention display high ratios of [-NH-CH₂-phenol] bonding expressed as percentages of the total bonding, and high co-condensation ratios between the phenol and the triazine derivative. Furthermore, the Mw/Mn ratios are low in comparison with the comparative examples, the molecular weight distribution is obviously narrow, and the softening points are low. Moreover, the resin compositions according to the present invention contained no unreacted triazines.

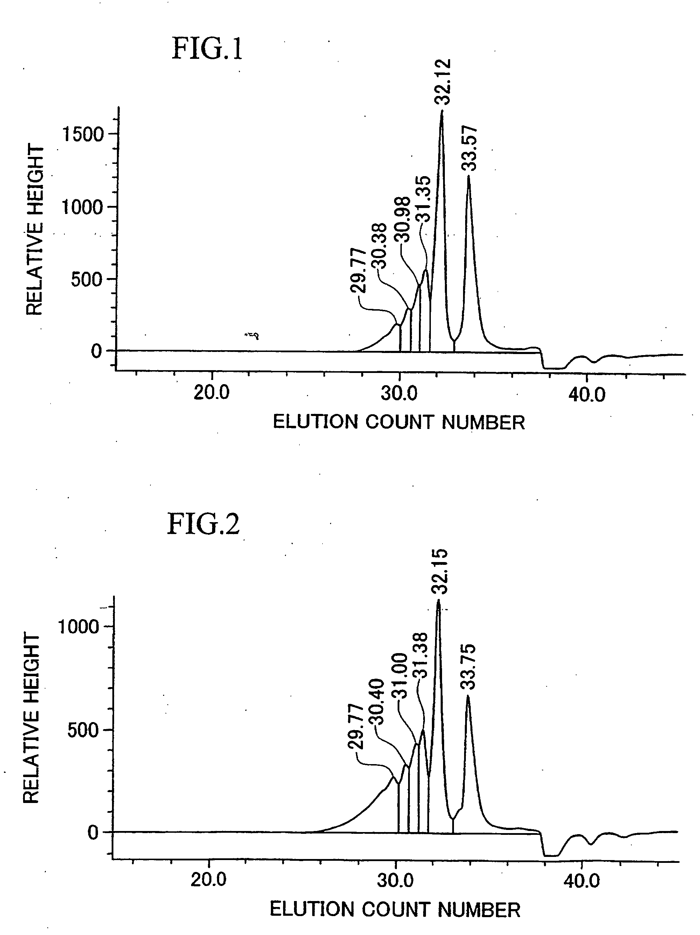

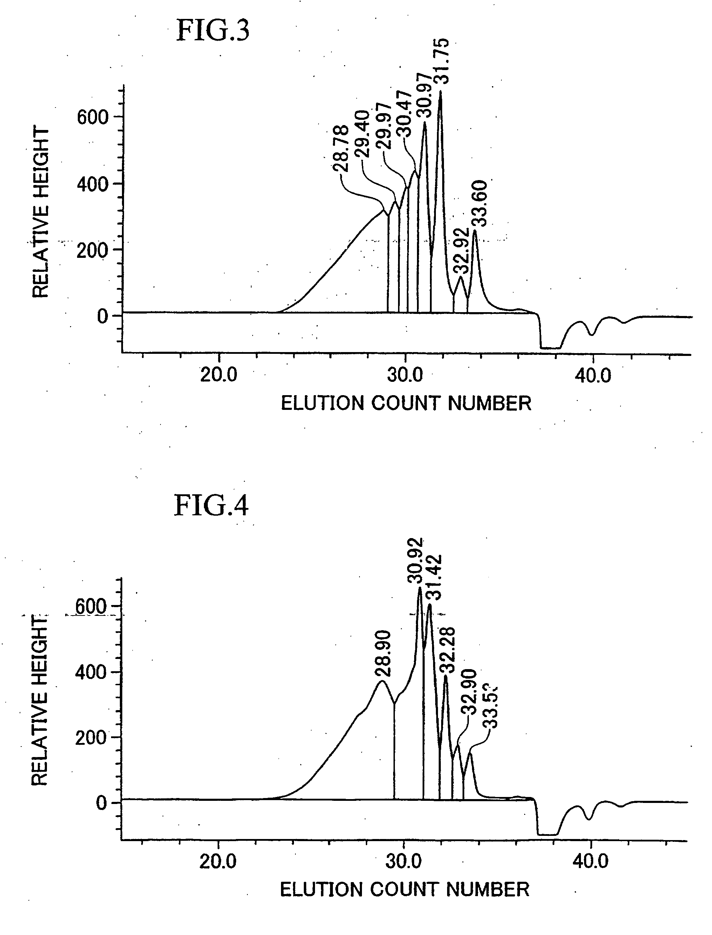

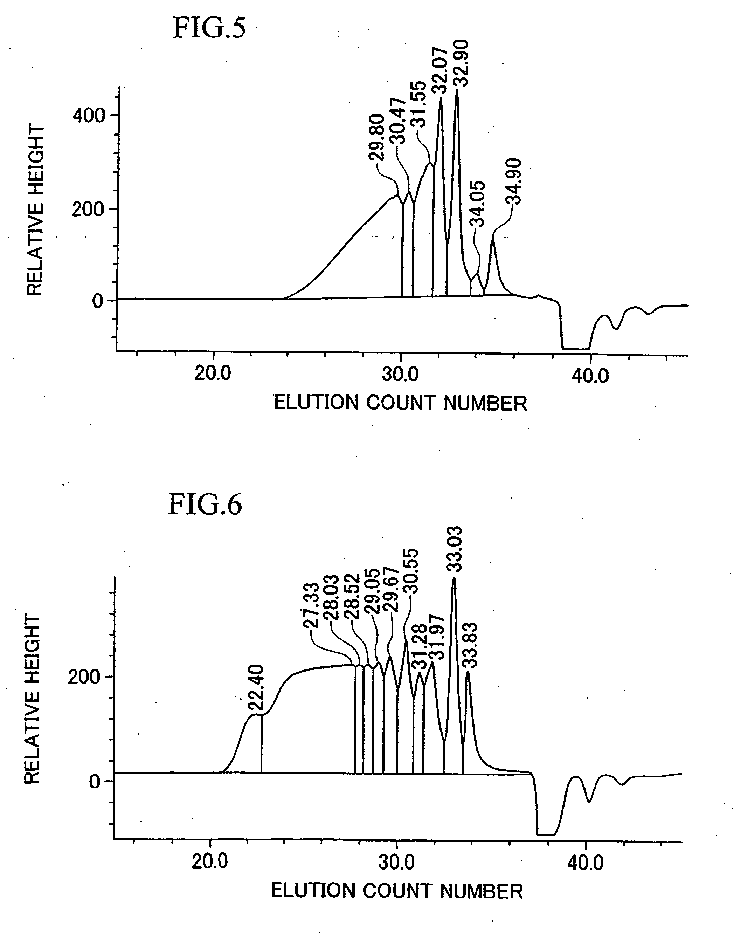

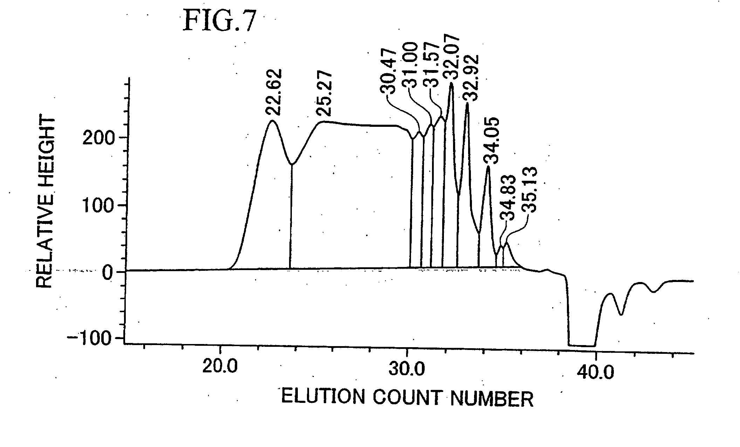

FIGS. 1∼5 show the GPC spectra for the working examples 1∼5 respectively, and FIGS. 6 and 7 show the GPC spectra for the comparative examples 1 and 2. Comparison of these graphs reveals that the resins of the working examples 1-5 display narrow molecular weight distributions.

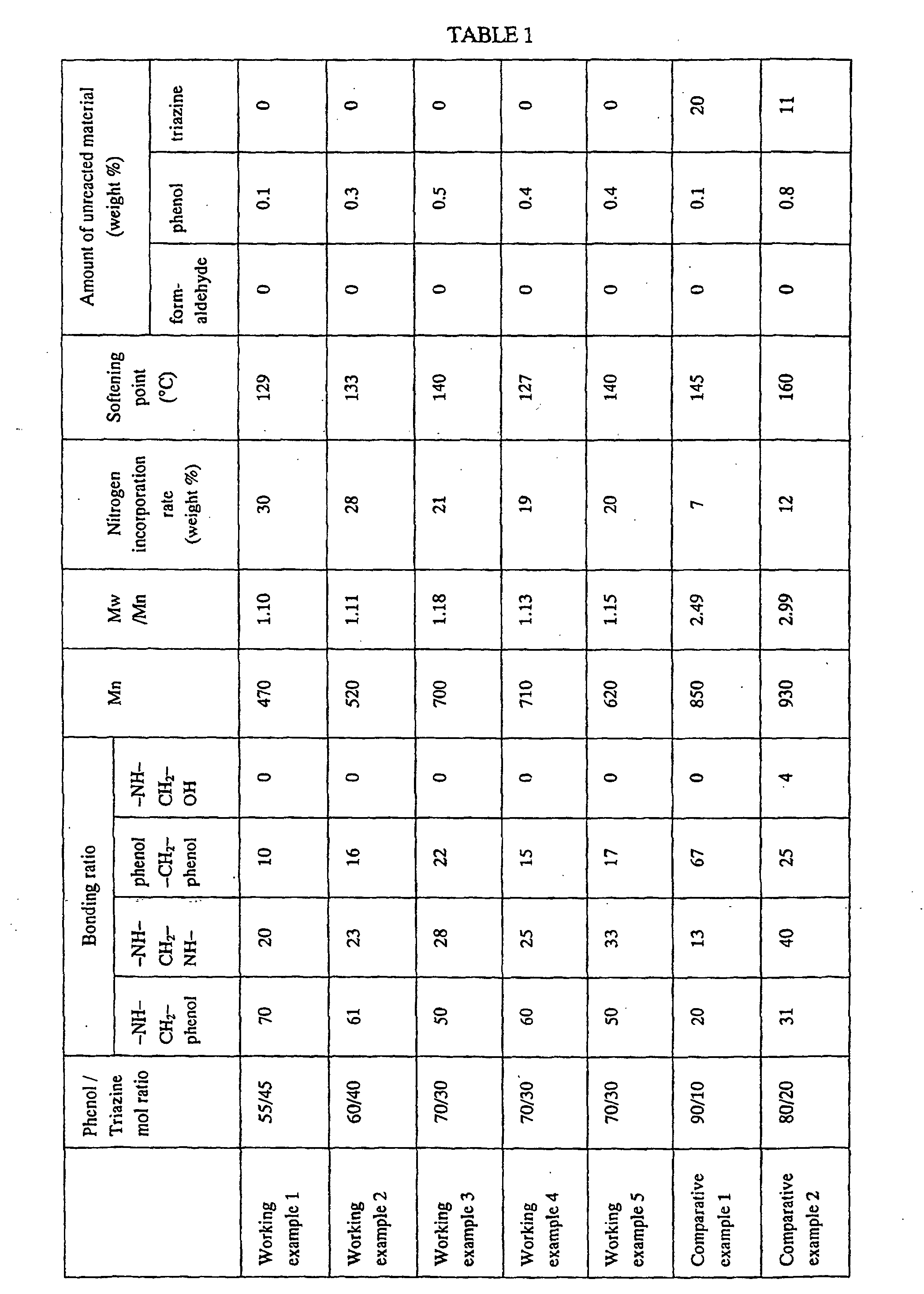

### INDUSTRIAL FIELD OF APPLICATION

For a phenol triazine derivative co-condensation resin of the present invention, the average proportion of the number of [-NH-CH₂-phenol] bonds, expressed as a percentage of the total bonding incorporating [-NH-CH₂-phenol] bonds, [-NH-CH₂-NH-] bonds and [phenol-CH₂-phenol] bonds, is between 30∼80%, the number average molecular weight (Mn) is between 300∼800, and the ratio (Mw/Mn) of the weight average molecular weight (Mw) to the number average molecular weight (Mn) is no more than 1.30, and consequently the resin displays high levels of durability, heat resistance, resistance to hydrolysis, and flame retardancy, does not release toxic gas on curing, and because the molecular weight distribution is narrow, has a low viscosity making manufacture and handling easier, and meaning degradation of compatibility is unlikely to occur. Consequently, the resins of the present invention can be ideally applied to the manufacture of laminates (printed circuit boards), friction materials, refractory products, sealants, grinding stones and molding materials.

## Claims

1. A phenol triazine derivative co-condensation resin which is a co-condensate of a triazine derivative and a phenol, wherein the average proportion of the amount of [-NH-CH₂-phenol] bonding, expressed as a percentage of the total bonding incorporating [-NH-CH₂-phenol] bonding, [-NH-CH₂-NH-] bonding and [phenol-CH₂-phenol] bonding, is between 30-80%, and wherein the number average molecular weight (Mn) is between 300-800 and the ratio (Mw/Mn) of the weight average molecular weight (Mw) to the number average molecular weight (Mn) is no more than 1.30.

2. A phenol triazine derivative co-condensation resin according to claim 1, wherein said triazine derivative is a compound of the structure shown in the formula (I) below. 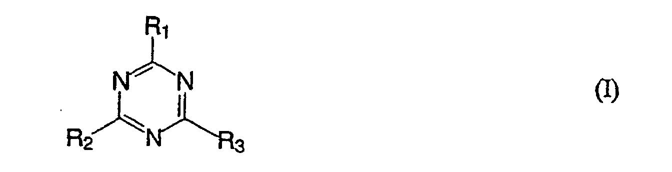 (In the formula, R1, R2, and R3 each represent one of the group consisting of an alkylated methylol group, a hydrogen atom, an amino group, an alkyl group, a phenyl group, a hydroxyl group, a hydroxylalkyl group, an ether group, an ester group, an acid group, an unsaturated group, a cyano group, or a halogen atom.)

3. A phenol triazine derivative co-condensation resin according to claim 2, wherein at least two of said groups R1, R2 and R3 from said formula (I) are alkylated methylol groups.

4. A phenol triazine derivative co-condensation resin according to claim 1, wherein said triazine derivative is either one, or alternatively a mixture of two or more, of the compounds selected from the group consisting of di-(alkylated methylol) melamine, tri-(alkylated methylol) melamine, di-(alkylated methylol) benzoguanamine, and di-(alkylated methylol) acetoguanamine.

5. A phenol triazine derivative co-condensation resin according to claim 1, wherein said phenol triazine derivative co-condensation resin is composed primarily of a mixture of a compound of the basic structure shown in the formula (II) below, a compound of the basic structure shown in the formula (III), a compound of the basic structure shown in the formula (IV), and a compound of the basic structure shown in the formula (V).

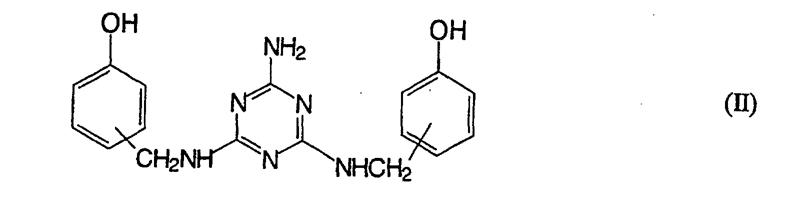

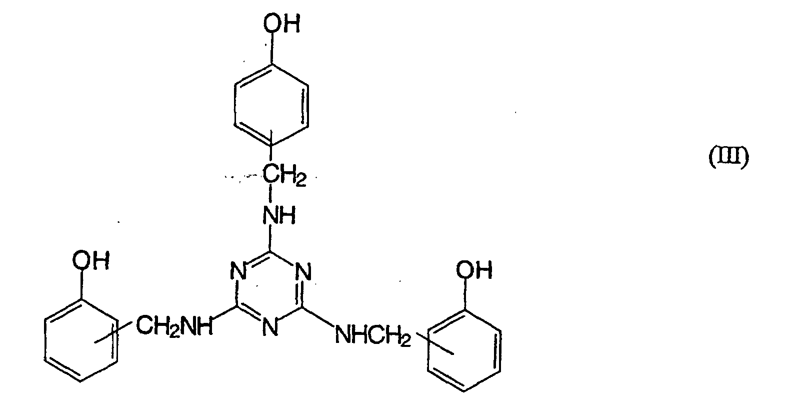

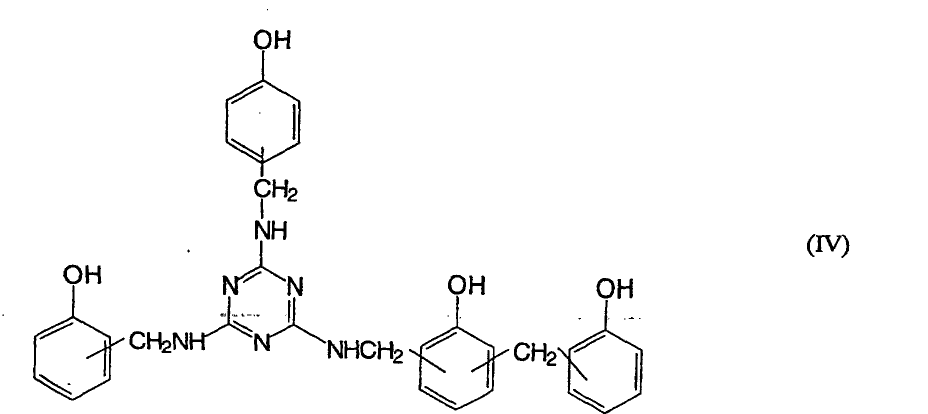

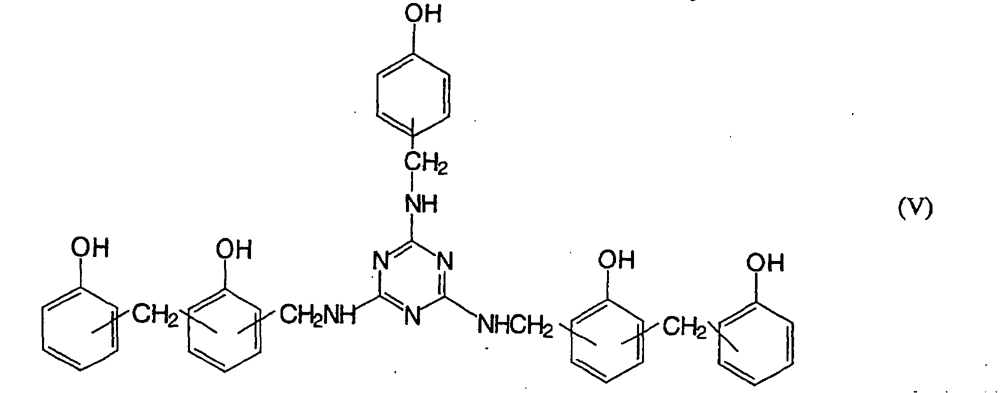

6. A phenol triazine derivative co-condensation resin according to claim 1, wherein at least a portion of the triazine derivative section is modified by an epoxy group.

7. Process for preparing a phenol triazine derivative co-condensation resin comprising the steps of:
i) preparing a methylolated triazine derivative by an addition reaction between an aldehyde and an triazine derivative;
ii) alkylating the methylol triazine derivative by subjecting it to a substitution reaction with an alcohol; and
iii) adding a phenol to the alkylated methylol triazine derivative and heating the mixture in the absence of free formalin to a temperature greater than 120°C to effect a co-condensation reaction through dealcoholization and dehydration.

8. A manufacturing method for preparing a phenol triazine derivative co-condensation resin according to claim 7, wherein the conditions for said addition reaction of an aldehyde to a triazine derivative comprise a mol ratio of between 0.5-6.0 for said aldehyde with respect to said triazine derivative, a pH of 5-8, and a reaction temperature of 50-80°C,
the conditions for said substitution reaction of said methylolated triazine derivative with an alcohol to form an alkylated methylol triazine derivative comprise a mol ratio of between 1-20 for said alcohol with respect to said triazine derivative, a pH of 5-8, and a reaction temperature of 50-80°C,
and the conditions for said co-condensation reaction of said alkylated methylol triazine derivative and a phenol comprise a mol ratio of between 1-20 for said phenol with respect to said triazine derivative, and a heating temperature of at least 120°C.

9. A manufacturing method for preparing a phenol triazine derivative co-condensation resin according to claim 7, wherein said phenol triazine derivative co-condensation resin is manufactured by selectively generating a methylolated triazine derivative by mixing said triazine derivative, said aldehyde, said phenol, and said alcohol, and then generating the alkylated methylol triazine derivative by a substitution reaction of said methylolated triazine derivative with said alcohol, and finally conducting a co-condensation of said alkylated methylol triazine derivative and said phenol by heating the mixture following formation of said alkylated methylol triazine derivative.

10. A manufacturing method for preparing a phenol triazine derivative co-condensation resin according to claim 9, wherein the conditions for said addition reaction of an aldehyde to a triazine derivative comprise a mol ratio of between 0.5-6.0 for said aldehyde with respect to said triazine derivative, a pH of 5-8, and a reaction temperature of 50-80°C,
the conditions for said substitution reaction of said methylolated triazine derivative with an alcohol to form an alkylated methylol triazine derivative comprise a mol ratio of between 1-20 for said alcohol with respect to said triazine derivative, a pH of 5-8, and a reaction temperature of 50-80°C,
and the conditions for said co-condensation reaction of said alkylated methylol triazine derivative and a phenol comprise a mol ratio of between 1-20 for said phenol with respect to said triazine derivative, and a heating temperature of at least 120°C.

11. Process for preparing a phenol triazine derivative co-condensation resin comprising the steps of:
i) preparing a methylolated phenol by an addition reaction between an aldehyde and an phenol;
ii) alkylating the methylol phenol by subjecting it to a substitution reaction with an alcohol; and
iii) adding a triazine derivative to the alkylated methylol phenol and heating the mixture in the absence of free formalin to a temperature greater than 120°C to effect a co-condensation reaction through dealcoholization and dehydration.

12. A manufacturing method for preparing a phenol triazine derivative co-condensation resin according to claim 11, wherein the conditions for said addition reaction of an aldehyde to a phenol comprise a mol ratio of between 0.5-6.0 for said aldehyde with respect to said phenol, a pH of 5-8, and a reaction temperature of 50-100°C,
the conditions for said substitution reaction of said methylolated phenol with an alcohol comprise a mol ratio of between 1-20 for said alcohol with respect to said methylolated phenol, a pH of 10-14, and a reaction temperature of 50-100°C,
and the conditions for said co-condensation reaction of said alkylated methylol phenol and a triazine derivative comprise a mol ratio of between 0.05-1.0 for said triazine derivative with respect to said alkylated methylol phenol, and a heating temperature of at least 120°C.

## Patentansprüche

1. Phenoltriazinderivat-Co-kondensationsharz, das ein Co-kondensat eines Triazinderivats mit einem Phenol darstellt, worin der durchschnittliche Anteil der Menge an [-NH-CH₂-Phenol]-Bindungen, ausgedrückt als Prozentsatz der gesamten Bindungen, die eine [-NH-CH₂-Phenol]-Bindung, [-NH-CH₂-NH-]-Bindung und [Phenol-CH₂-Phenol]-Bindung einschliessen, zwischen 30 und 80 % beträgt, und worin das Zahlendurchschnitts-Molekulargewicht (Mn) zwischen 300 und 800 und das Verhältnis (Mw/Mn) des Gewichtsdurchschnitts-Molekulargewichts (Mw) zum Zahlendurchschnitts-Molekulargewicht (Mn) nicht mehr als 1,30 beträgt.

2. Phenoltriazinderivat-Co-kondensationsharz gemäss Anspruch 1, worin das Triazinderivat eine Verbindung mit einer Struktur der unten gezeigten Formel (I) ist: 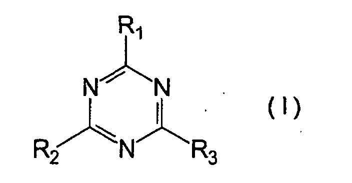 (in der Formel repräsentieren R₁, R₂ und R₃ jeweils eines, ausgewählt aus einer alkylierten Methylolgruppe, einem Wasserstoffatom, einer Aminogruppe, einer Alkylgruppe, einer Phenylgruppe, einer Hydroxygruppe, einer Hydroxyalkylgruppe, einer Ethergruppe, einer Estergruppe, einer Säuregruppe, einer ungesättigten Gruppe, einer Cyanogruppe oder einem Halogenatom).

3. Phenoltriazinderivat-Co-kondensationsharz gemäss Anspruch 2, worin mindestens zwei der Gruppen R₁, R₂ und R₃ in Formel (I) alkylierte Methylolgruppen sind.

4. Phenoltriazinderivat-Co-kondensationsharz gemäss Anspruch 1, worin das Triazinderivat eine einzelne oder, alternativ dazu, eine Mischung aus zwei oder mehreren aus den Verbindungen, ausgewählt aus Di-(alkyliertes Methylol)melamin, Tri-(alkyliertes Methylol)melamin, Di-(alkyliertes Methylol)benzoguanamin und Di-(alkyliertes Methylol)acetoguanamin, darstellt.

5. Phenoltriazinderivat-Co-kondensationsharz gemäss Anspruch 1, worin das Phenoltriazinderivat-Co-kondensationsharz vorwiegend aus einer Mischung aus einer Verbindung der unten in Formel (II) gezeigten Grundstruktur, einer Verbindung der in Formel (III) gezeigten Grundstruktur, einer Verbindung der in Formel (IV) gezeigten Grundstruktur und einer Verbindung der in Formel (V) gezeigten Grundstruktur zusammengesetzt ist:

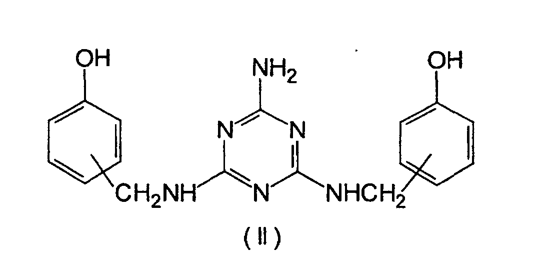

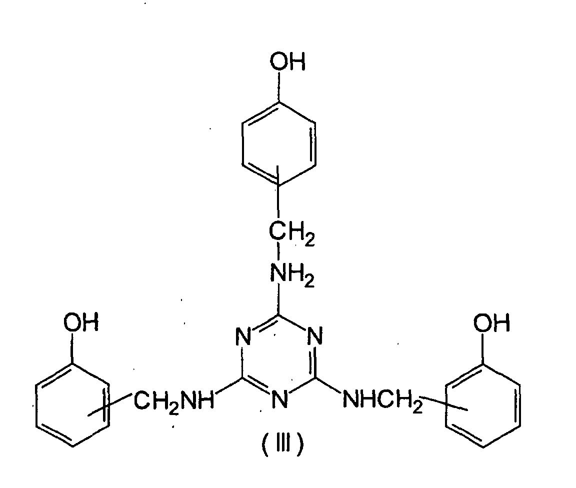

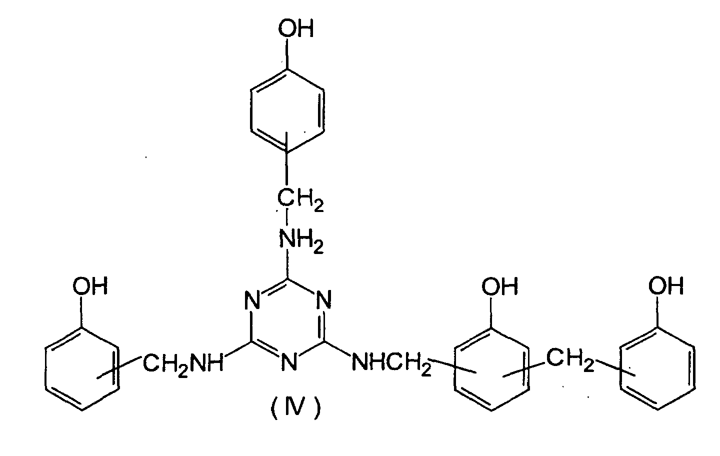

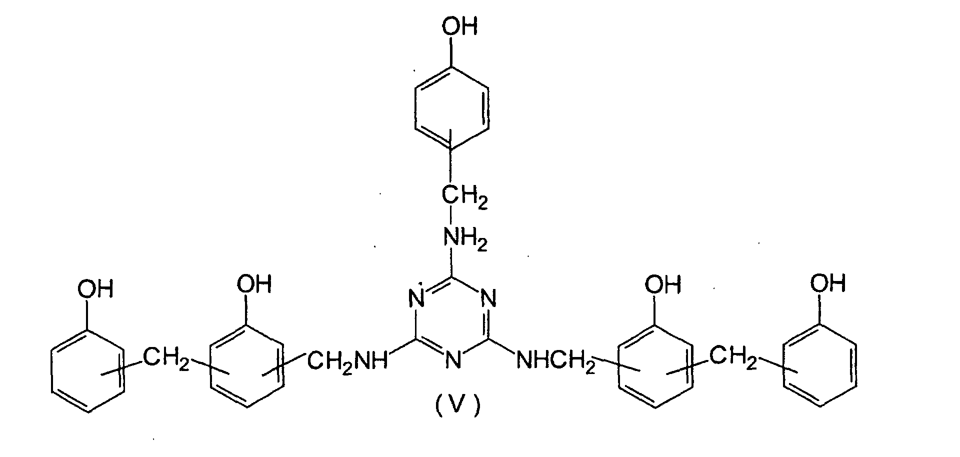

6. Phenoltriazinderivat-Co-kondensationsharz gemäss Anspruch 1, worin zumindest ein Teil des Triazinderivatanteils durch eine Epoxygruppe modifiziert ist.

7. Verfahren zur Herstellung eines Phenoltriazinderivat-Co-kondensationsharzes, das die folgenden Schritte umfasst:
(i) Herstellen eines methylolierten Triazinderivats durch eine Additionsreaktion zwischen einem Aldehyd und einem Triazinderivat;
(ii) Alkylieren des Methyloltriazinderivats mittels Durchführung einer Substitutionsreaktion mit einem Alkohol; und
(iii) Zugabe eines Phenols zu dem alkylierten Methyloltriazinderivat und Erwärmen der Mischung in Abwesenheit von freiem Formalin auf eine Temperatur von mehr als 120°C, wodurch eine Co-kondensationsreaktion durch Dealkoholisierung und Dehydratisierung bewirkt wird.

8. Herstellungsverfahren zur Herstellung eines Phenoltriazinderivat-Co-kondensationsharzes gemäss Anspruch 7, worin die Bedingungen für die Additionsreaktion eines Aldehyds mit einem Triazinderivat ein Molverhältnis von 0,5-6,0 für das Aldehyd bezüglich des Triazinderivats, einen pH-Wert von 5-8 und eine Reaktionstemperatur von 50-80°C umfassen,
die Bedingungen für die Substitutionsreaktion des methylolierten Triazinderivats mit einem Alkohol
unter Bildung eines alkylierten Methyloltriazinderivats umfassen ein Molverhältnis von 1-20 für den Alkohol in bezug auf das Triazinderivat, einen pH-Wert von 5-8 und eine Reaktionstemperatur von 50-80°C,
und die Bedingungen für die Co-kondensationsreaktion des alkylierten Methyloltriazinderivats mit einem Phenol umfassen ein Molverhältnis von 1-20 für das Phenol in bezug auf das Triazinderivat, und eine Erwärmungstemperatur von mindestens 120°C.

9. Herstellungsverfahren zur Herstellung eines Phenoltriazinderivat-Co-kondensationsharzes gemäss Anspruch 7, worin das Phenoltriazinderivat-Co-kondensationsharz hergestellt wird durch selektive Erzeugung eines methylolierten Triazinderivats durch Vermischen des Triazinderivats, des Aldehyds, des Phenols und des Alkohols und anschliessende Erzeugung des alkylierten Methyloltriazinderivats durch eine Substitutionsreaktion des methylolierten Triazinderivats mit dem Alkohol, und schlussendlich Durchführung einer Co-kondensation des alkylierten Methyloltriazinderivats mit dem Phenol durch Erwärmen der Mischung nach der Bildung des alkylierten Methyloltriazinderivats.

10. Herstellungsverfahren zur Herstellung eines Phenoltriazinderivat-Co-kondensationsharzes gemäss Anspruch 9, worin die Bedingungen für die Additionsreaktion des Aldehyds mit dem Triazinderivat ein Molverhältnis von 0,5-6,0 für das Aldehyd in bezug auf das Triazinderivat, einen pH-Wert von 5-8 und eine Reaktionstemperatur von 50-80°C umfassen, die Bedingungen für die Substitutionsreaktion des methylolierten Triazinderivats mit einem Alkohol unter Bildung eines alkylierten Methyloltriazinderivats umfassen ein Molverhältnis von 1-20 für den Alkohol in bezug auf das Triazinderivat, einen pH-Wert von 5-8 und eine Reaktionstemperatur von 50-80°C,
und die Bedingungen für die Co-kondensationsreaktion des alkylierten Methyloltriazinderivats mit einem Phenol umfassen ein Molverhältnis von 1-20 für das Phenol in bezug auf das Triazinderivat, und eine Erwärmungstemperatur von mindestens 120°C.

11. Verfahren zur Herstellung eines Phenoltriazinderivat-Co-kondensationsharzes, das die folgenden Schritte umfasst:
(i) Herstellen eines methylolierten Phenols durch eine Additionsreaktion zwischen einem Aldehyd und einem Phenol;
(ii) Alkylieren des Methylolphenols mittels Durchführung einer Substitutionsreaktion mit einem Alkohol; und
(iii) Zugabe eines Triazinderivats zu dem alkylierten Methylolphenol und Erwärmen der Mischung in Abwesenheit von freiem Formalin auf eine Temperatur von mehr als 120°C, wodurch eine Co-kondensationsreaktion durch Dealkoholisierung und Dehydratisierung bewirkt wird.

12. Herstellungsverfahren zur Herstellung eines Phenoltriazinderivat-Co-kondensationsharzes gemäss Anspruch 11, worin die Bedingungen für die Additionsreaktion des Aldehyds mit einem Phenol ein Molverhältnis von 0,5-6,0 für das Aldehyd in bezug auf das Phenol, einen pH-Wert von 5-8 und eine Reaktionstemperatur von 50-100°C umfassen,
die Bedingungen für die Substitutionsreaktion des methylolierten Phenols mit einem Alkohol umfassen ein Molverhältnis von 1-20 für den Alkohol in bezug auf das methylolierte Phenol, einen pH-Wert von 10-14 und eine Reaktionstemperatur von 50-100°C,
und die Bedingungen für die Co-kondensationsreaktion des alkylierten Methylolphenols mit dem Triazinderivat umfassen ein Molverhältnis von 0,05-1,0 für das Triazinderivat in bezug auf das alkylierte Methylolphenol, und eine Erwärmungstemperatur von mindestens 120°C.

## Revendications

1. Une résine de co-condensation de dérivé de triazine phénol qui est un co-condensat d'un dérivé de triazine et d'un phénol, dans laquelle la proportion moyenne de la quantité de liaison [-NH-CH₂-phenol], exprimée en tant que pourcentage de la totalité des liaisons incorporant la liaison [-NH-CH₂-phenol], la liaison [-NH-CH₂-NH-] et la liaison [-phénol-CH₂-phenol], est entre 30 et 80%, et dans lequel le poids moléculaire moyen en nombre (Mn) est entre 300 et 800 et le rapport (Mw/Mn) du poids moléculaire moyen en poids (Mw) au poids moléculaire moyen en nombre (Mn) n'est pas supérieur à 1,30.

2. Une résine de co-condensation de dérivé de triazine phénol selon la revendication 1, dans laquelle ledit dérivé de triazine est un composé de structure représentée par la formule (I) ci-dessous. 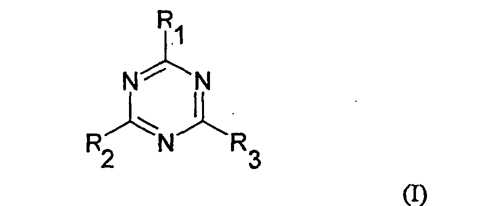 (dans la formule, R₁, R₂ et R₃ représentent chacun un parmi le groupe constitué d'un groupe méthylol alcoylé, d'un atome d'hydrogène, d'un groupe amino, d'un groupe alcoyle, d'un groupe phényle, d'un groupe hydroxyle, d'un groupe hydroxyalcoyle, d'un groupe éther, d'un groupe ester, d'un groupe acide, d'un groupe insaturé, d'un groupe cyano ou d'un atome d'halogène)

3. Une résine de co-condensation de dérivé de triazine phénol selon la revendication 2, dans laquelle au moins deux desdits groupes R₁, R₂ et R₃ provenant de la formule (I) sont des groupes méthylol alcoylés.

4. Une résine de co-condensation de dérivé de triazine phénol selon la revendication 1, dans laquelle ledit dérivé de triazine est soit l'un, ou alternativement un mélange de deux ou davantage, des composés sélectionnés parmi le groupe constitué de la mélamine di-(méthylol alcoylée), la mélamine tri-(méthylol alcoylée), la benzoguanamine di-(méthylol alcoylée), et l'acétoguanamine di-(méthylol alcoylée).

5. Une résine de co-condensation de dérivé de triazine phénol conforme à la revendication 1, dans laquelle ladite résine de co-condensation de dérivé de triazine phénol est composée principalement d'un mélange d'un composé de la structure de base représentée par la formule (II) ci-dessous, d'un composé de la structure de base représentée par la formule (III), d'un composé de la structure de base représentée par la formule (IV), et d'un composé de la structure de base représentée par la formule (V).

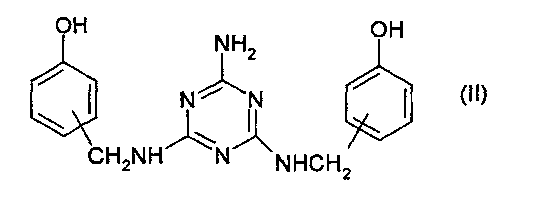

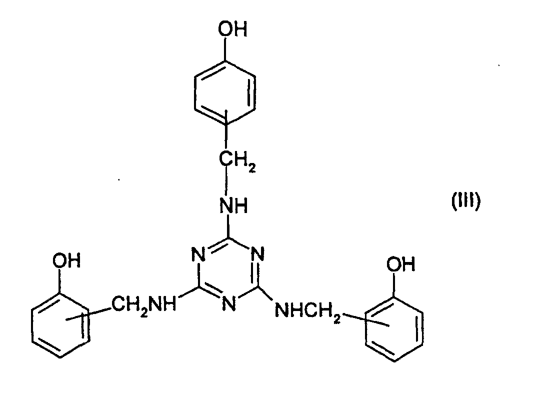

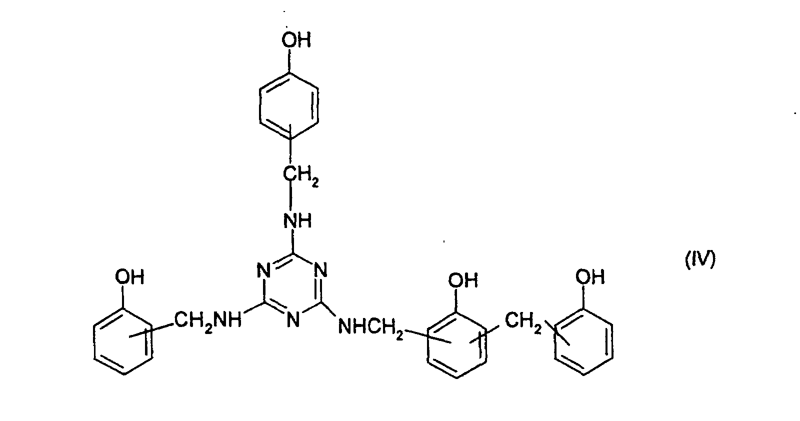

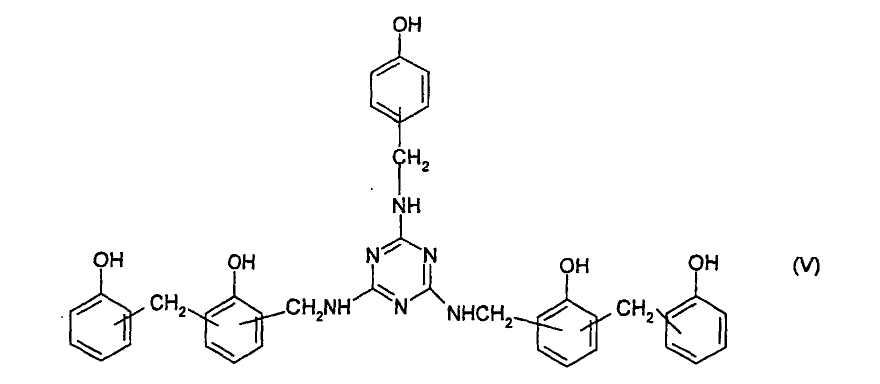

6. Une résine de co-condensation de dérivé de triazine phénol selon la revendication 1, dans laquelle au moins une partie de la section dérivée de triazine est modifiée par un groupe époxy.

7. Procédé pour préparer une résine de co-condensation de dérivé de triazine phénol comprenant les étapes consistant à :
i) préparer un dérivé méthylolé de triazine par une réaction d'addition entre un aldéhyde et un dérivé de triazine;
ii) alcoyler le dérivé méthylolé de triazine en le soumettant à une réaction de substitution avec un alcool ; et
iii) ajouter un phénol au dérivé de triazine méthylol alcoylé et chauffer le mélange en l'absence de formaline libre jusqu'à une température supérieure à 120°C pour effectuer une réaction de co-condensation à travers une désalcoolisation et une déshydratation.

8. Une méthode de fabrication pour préparer une résine de co-condensation de dérivé de triazine phénol selon la revendication 7, dans laquelle les conditions pour ladite réaction d'addition d'un aldéhyde sur un dérivé de triazine comprennent un rapport molaire entre 0,5 et 6,0 pour ledit aldéhyde par rapport audit dérivé de triazine, un pH de 5 à 8, et une température réactionnelle de 50 à 80°C, les conditions pour ladite réaction de substitution dudit dérivé méthylolé de triazine par un alcool pour former un dérivé de triazine méthylol alcoylé comprennent un rapport molaire entre 1 et 20 pour ledit alcool par rapport audit dérivé de triazine, un pH de 5 à 8, et une température réactionnelle de 50 à 80°C, et les conditions pour ladite réaction de co-condensation dudit dérivé de triazine méthylol alcoylé et d'un phénol comprennent un rapport molaire entre 1 et 20 pour ledit phénol par rapport audit dérivé de triazine, et une température de chauffage d'au moins 120°C.

9. Une méthode de fabrication pour préparer une résine de co-condensation de dérivé de triazine phénol selon la revendication 7, dans laquelle ladite résine de co-condensation de dérivé de triazine phénol est fabriquée en générant sélectivement un dérivé de triazine méthylolé en mélangeant ledit dérivé de triazine, ledit aldéhyde, ledit phénol, et ledit alcool, puis en générant le dérivé de triazine méthylol alcoylé par une réaction de substitution dudit dérivé méthylolé de triazine par ledit alcool, et finalement en conduisant une co-condensation dudit dérivé de triazine méthylol alcoylé et dudit phénol en chauffant le mélange après la formation dudit dérivé de triazine méthylol alcoylé.

10. Une méthode de fabrication pour préparer une résine de co-condensation de dérivé de triazine phénol selon la revendication 9, dans laquelle les conditions pour ladite réaction d'addition d'un aldéhyde sur un dérivé de triazine comprennent un rapport molaire entre 0,5 et 6,0 pour ledit aldéhyde par rapport audit dérivé de triazine, un pH de 5 à 8, et une température réactionnelle de 50 à 80°C, les conditions pour ladite réaction de substitution dudit dérivé méthylolé de triazine par un alcool pour former un dérivé de triazine méthylol alcoylé comprennent un rapport molaire entre 1 et 20 pour ledit alcool par rapport audit dérivé de triazine, un pH de 5 à 8, et une température réactionnelle de 50 à 80°C, et les conditions pour ladite réaction de co-condensation dudit dérivé de triazine méthylol alcoylé et d'un phénol comprennent un rapport molaire entre 1 et 20 pour ledit phénol par rapport audit dérivé de triazine, et une température de chauffage d'au moins 120°C.

11. Procédé pour préparer une résine de co-condensation de dérivé de triazine phénol comprenant les étapes consistant à :
i) préparer un phénol méthylolé par une réaction d'addition entre un aldéhyde et un phénol ;
ii) alcoyler le phénol méthylolé en le soumettant à une réaction de substitution avec un alcool ; et
iii) ajouter un dérivé de triazine au phénol méthylol alcoylé et chauffer le mélange en l'absence de formaline libre jusqu'à une température supérieure à 120°C pour effectuer une réaction de co-condensation à travers une désalcoolisation et une déshydratation.

12. Une méthode de fabrication pour préparer une résine de co-condensation de dérivé de triazine phénol selon la revendication 11, dans laquelle les conditions pour ladite réaction d'addition d'un aldéhyde sur un phénol comprennent un rapport molaire entre 0,5 et 6,0 pour ledit aldéhyde par rapport audit phénol, un pH de 5 à 8, et une température réactionnelle de 50 à 100°C, les conditions pour ladite réaction de substitution dudit phénol méthylolé par un alcool comprennent un rapport molaire entre 1 et 20 pour ledit alcool par rapport audit phénol méthylolé, un pH de 10 à 14, et une température réactionnelle de 50 à 100°C, et les conditions pour ladite réaction de co-condensation dudit phénol méthylol alcoylé et d'un . dérivé de triazine comprennent un rapport molaire entre 0,05 et 1,0 pour ledit dérivé de triazine par rapport audit phénol méthylol alcoylé, et une température de chauffage d'au moins 120°C.
